# EUROPÄISCHE PATENTSCHRIFT

(11) **EP 2 828 885 B1**
(45) Veröffentlichungstag und Bekanntmachung des Hinweises auf die Patenterteilung: **15.08.2018**
(21) Anmeldenummer: 12713633.1
(22) Anmeldetag: 19.03.2012
(51) Int. Cl.: B23K 20/02, H01L 21/67, B23K 20/22, B23K 101/40

(54) **DRUCKÜBERTRAGUNGSPLATTE ZUR DRUCKÜBERTRAGUNG EINES BONDINGDRUCKS**
PRESSURE TRANSFER PLATE FOR PRESSURE TRANSFER OF A BONDING PRESSURE
PLAQUE DE TRANSMISSION DE PRESSION SERVANT À TRANSMETTRE UNE PRESSION D'ASSEMBLAGE

(43) Veröffentlichungstag der Anmeldung: 28.01.2015
(73) Patentinhaber: Ev Group E. Thallner GmbH, 4782 St. Florian am Inn (AT)
(72) Erfinder: BURGGRAF, Jürgen, A-4780 Schärding (AT); HANGWEIER, Peter-Oliver, A-4742 Pram (AT); PERAU, Christian, A-4950 Altheim (AT)
(74) Vertreter: Schneider, Sascha
(86) Internationale Anmeldenummer: PCT/EP2012/054808
(87) Internationale Veröffentlichungsnummer: WO 2013/139366

(56) Entgegenhaltungen:
- EP-A1- 2 397 246
- EP-A2- 0 435 423
- WO-A1-80/01967
- GB-A- 2 287 897
- US-A1- 2002 096 551
- US-A1- 2007 181 633
- US-A1- 2010 301 191

## Beschreibung

Die vorliegende Erfindung betrifft eine Druckübertragungsplatte zur Druckübertragung eines Bondingdrucks beim Thermokompressionsbonden, von einer Druckbeaufschlagungseinrichtung auf einen Wafer gemäß Anspruch 1 sowie eine Verwendung gemäß Anspruch 7.

Eine der unzähligen Bondverfahren ist das Thermokompressionsbonden. Bei diesem Bondingverfahren werden zwei Wafer bei sehr hohen Drücken und Temperaturen zueinander permanent verbunden/gebonded. Um ein möglichst homogenes Bondinginterface zu erhalten, werden die Werkzeuge, die Bondchucks (Bond Probenhalter) und die Druckplatten (pressure discs) mit möglichst geringen Oberflächenrauigkeiten gefertigt. Mit Vorzug haben diese Werkzeuge überhaupt keine Oberflächenrauigkeit, sind perfekt planar und haben möglichst keine Fehlstellen. Zum Ausgleich etwaiger makroskopischer Unebenheiten und/oder Welligkeiten können auf einer oder auf beiden Seiten der Druckplatten Ausgleichsplatten, beispielsweise Graphitplatten, befestigt werden. Diese Ausgleichsplatten sind weich und verformbar. Die Ausgleichsplatten befinden sich im Bondprozess demnach zwischen der pressure-disc und dem dahinterliegenden Werkzeug und/oder der Oberseite eines zu bondenden Wafers.

Die Druckschrift US 2007/181633 offenbart einen Bondingmechanismus mit einem elastischen Interface. Die Druckschrift WO 80/01967 offenbart eine Vorrichtung zum Thermokompressionsbonden mit Spannungspuffern aus Kupfer.

Für die meisten Bondingverfahren erfüllen die Ausgleichsplatten ihre Aufgabe, Unebenheiten auszugleichen. Dies tun sie vor allem durch eine effiziente Auffüllung des Raumes zwischen Ausgleichsplatte und Wafer Allerdings entsteht beim Thermokompressionsbonden das Problem, dass die Kompensation der Unebenheiten durch diese Auffüllung aufgrund der hohen Drücke und Temperaturen mittlerweile so effizient ist, dass die Wafer an der pressure-disc oder der Ausgleichsplatte hängen bleiben. Wird die Bondkammer nach dem Bondvorgang geöffnet, kommt es somit vor, dass der Wafer hierdurch beschädigt wird. Die Beschädigung erfolgt hauptsächlich dadurch, dass der Wafer beim Öffnen der Bondkammer an der Oberfläche der pressure-disc oder der Ausgleichsplatte haftet und nach einigen Millisekunden bis Sekunden spontan die Adhäsion verliert. Dadurch fällt der Wafer zurück, schlägt auf und wird beschädigt.

Es ist daher die Aufgabe der vorliegenden Erfindung, eine Druckübertragungsplatte anzugeben, mit der Beschädigungen beim Bonden vermieden werden können, insbesondere bei der Entnahme des gebondeten Wafers aus der Bondingvorrichtung.

Diese Aufgabe wird mit den Merkmalen der Ansprüche 1 und 7 gelöst. Vorteilhafte Weiterbildungen der Erfindung sind in den Unteransprüchen angegeben.

Der Erfindung liegt der Gedanke zugrunde, durch Anbringung einer gegenüber Wafern gering adhäsiven Druckübertragungsplatte an der Druckbeaufschlagungseinrichtung, mithin zwischen der Druckübertragungsplatte und dem Wafer, das Ablösen des Wafers von der Druckbeaufschlagungseinrichtung zu erleichtern und dadurch Beschädigungen zu vermeiden. Durch die Reduzierung der Adhäsion kann der Wafer nach dem Bonden von der jeweiligen Druckplatte gelöst werden, ohne dass durch Anhaften eine Beschädigung des Wafers, beispielsweise durch Herunterfallen, erfolgt. Erfindungsgemäß wird ein verlässliches Lösen von der Druckübertragungsplatte bei Beibehaltung der restlichen, vorteilhaften Eigenschaften gewährleistet.

Mit Adhäsionsfähigkeit ist erfindungsgemäß insbesondere eine bestimmte Haltekraft pro m² bezeichnet, die erfindungsgemäß möglichst gering sein sollte, so dass der weit überwiegende Teil der Fixierung des Substrats an der Aufnahmefläche durch Fixiermittel im Fixierabschnitt bewirkt wird.

Möchte man die Adhäsion zwischen zwei miteinander verbundenen Festkörpern bestimmen, kann man die Energie messen, die benötigt wird, um einen Riss durch den Festkörper zu treiben. In der Halbleiterindustrie wird der sogenannte "Rasierklingentest" oder "Maszara Rasierklingentest" häufig verwendet. Bei diesem Test handelt es sich streng genommen um eine Methode, um die Bindungsenergie zwischen zwei Festkörpern zu bestimmen. Meistens sind die Festkörper miteinander verschweißt. Um nun die Adhäsionsfähigkeit einer Schicht zu bestimmen, welche gegenüber möglichst vielen anderen Materialien niedrigadhäsiv sein soll, werden erfindungsgemäß bevorzugt andere Messmethoden verwendet. Die am häufigsten eingesetzte Messmethode ist die Kontaktwinkelmethode.

Die Kontaktwinkelmethode wird zusammen mit der Youngschen Gleichung verwendet, um eine Aussage über die Oberflächenenergie eines Festkörpers, durch die Verwendung einer Prüfflüssigkeit, zu erhalten.

Diese qualifiziert die Oberflächenenergie einer Oberfläche durch eine gewisse Prüfflüssigkeit, meistens durch Wasser. Dem Fachmann sind entsprechende Messmethoden, sowie die Auswertungsmethoden bekannt. Der mit der Kontaktwinkelmethode ermittelte Kontaktwinkel kann auf eine Oberflächenenergie in N/m oder in J/m² umgerechnet werden. Für Relativvergleiche unterschiedlicher Oberflächen bei gleicher Prüfflüssigkeit reichen allerdings schon die Angaben der Kontaktwinkel aus, um eine (relative) Abschätzung der Adhäsionsfähigkeit der Oberfläche zu erhalten. So kann man durch die Verwendung von Wasser als Prüfflüssigkeit sagen, dass benetzte Oberflächen, die einen Kontaktwinkel am Wassertropfen von ca. 30° erzeugen, eine höhere Adhäsion (streng genommen nur zu Wasser) besitzen, als Oberflächen, deren Kontaktwinkel am Wassertropfen ca. 120° besitzt.

Die erfindungsgemäße Ausführungsform wird vorzugsweise zur Druckbeaufschlagung von Si-Waferns verwendet werden. Daher wäre eine Ermittlung der Oberflächenenergie einer beliebigen, erfindungsgemäß verwendeten Niedrigadhäsionsschicht zu Si wünschenswert. Da Si bei Raumtemperatur nicht flüssig ist, wird, wie oben erwähnt, eine Prüfflüssigkeit verwendet um die erfindungsgemäße Niedrigadhäsionsschicht bezüglich dieser Prüfflüssigkeit zu charakterisieren. Alle folgenden Kontaktwinkelwerte und/oder Oberflächenenergien sind damit Werte, welche die erfindungsgemäße Niedrigadhäsionsschicht bezüglich einer Prüfflüssigkeit quantifizieren und zumindest eine relative Aussage über die Adhäsionsfähigkeit zu anderen Substanzen, vorzugsweise Festkörpern, noch bevorzugter Si, erlauben.

In einer bevorzugten Ausführungsform der Erfindung ist es vorgesehen, dass die Adhäsionsfähigkeit durch eine Oberflächenenergie von kleiner 0,1 J/m², insbesondere kleiner 0,01 J/m², vorzugsweise kleiner 0,001 J/m², noch bevorzugter kleiner 0,0001 J/m², idealerweise kleiner 0,00001 J/m² definiert ist.

Alternativ oder zusätzlich ist es gemäß einer vorteilhaften Ausführungsform der Erfindung vorgesehen, dass die Adhäsionsfähigkeit der Kontaktfläche mit einem Kontaktwinkel größer 20°, insbesondere größer 50°, vorzugsweise größer 90°, noch bevorzugter größer 150°, definiert ist. Die Adhäsionsfähigkeit einer Oberfläche zu einem anderen Material kann mit Hilfe der oben genannten Kontaktwinkelmethode bestimmt werden. Dabei wird ein Tropfen einer bekannten Flüssigkeit, vorzugsweise Wasser (erfindungsgemäße Werte bezogen auf Wasser), (alternativ Glyzerin oder Hexadekan), auf der zu messenden Oberfläche abgeschieden. Mit Hilfe eines Mikroskops wird der Winkel von der Seite exakt vermessen, nämlich der Winkel zwischen der Tangente an den Tropfen und der Oberfläche.

Gemäß der Ausführungsform der Erfindung ist vorgesehen, dass die Druckübertragungsplatte als Gitternetz, insbesondere mit einer Maschenweite M kleiner 2mm, vorzugsweise kleiner 1mm, bevorzugter kleiner 0,5mm, noch bevorzugter kleiner 0.1mm, am bevorzugtesten kleiner 0,01mm ausgebildet ist. Für einen Fachmann auf dem Gebiet ist klar, dass die optimale Maschenweite auch vom Durchmesser und der Dicke des Wafers abhängen kann und insbesondere durch Versuche empirisch ermittelt wird. Die Antihaftwirkung wird durch die sehr geringe, aber endliche Maschenweite M hervorgerufen. Die Maschenweite M ist erfindungsgemäß gering genug, um die homogene Druckverteilung der Druckübertragungseinrichtung bestmöglich an eine Oberfläche des Wafers zu übertragen, verringert gleichzeitig die absolute Kontaktfläche derart, dass eine Adhäsion des Wafers an der Druckübertragungseinrichtung, insbesondere an einem oberen Werkzeug, nicht mehr möglich ist beziehungsweise zumindest geringer ist als die Gewichtskraft des Wafers.

Alternativ oder zusätzlich hierzu ist in Weiterbildung der Erfindung vorgesehen, dass zumindest die Kontaktfläche der zweiten Druckseite eine, insbesondere durch Kugelstrahlen, Sandstrahlen, Schleifen, Ätzen und/oder Polieren erzeugte, Oberflächenrauigkeit zwischen 100nm und 100µm, insbesondere zwischen 1µm und 10µm, noch bevorzugter zwischen 3µm und 5µm. Die Oberflächenrauhigkeit kann im speziellen auch auf die Waferdicke und/oder den Waferdurchmesser bezogen werden. Es kann sich ergeben, dass für einen gewissen Waferduchmesser und/oder eine gewisse Waferdicke eine optimale Rauhigkeit existiert. Diese wird erfindungsgemäß dann entsprechend empirisch ermittelt. In einer bevorzugten Ausführungsform wird die Oberflächenrauigkeit nasschemisch hergestellt. Durch den Einsatz von Säuren wird die Oberfläche gezielt erodiert. Durch die angegebenen Verfahren Kugelstrahlen, Sandstrahlen, Schleifen und/oder Polieren mit entsprechend großen Körnungen wird eine Oberfläche mit entsprechender Rauigkeit hergestellt. Der dadurch entstehende Effekt der Antihaftwirkung ist ähnlich dem Effekt des Gitternetzes, nur dass in diesem Fall keine regelmäßige Maschenstruktur, sondern eine unregelmäßige Oberfläche den gewünschten Effekt der Niedrigadhäsion hervorruft.

Aus der Nanotechnik ist bekannt, dass gerade Niedrigadhäsionsoberflächen im Mikro- und/oder Nanobereich extreme Unebenheiten besitzen, deren Morphologie gerade zur Niedrigadhäsion beiträgt oder sie sogar hervorruft. Ein Beispiel, welches dem Fachmann bekannt ist, ist der sogenannte "Lotusblüteneffekt".

Soweit die Druckübertragungsplatte aus einem Material gebildet ist, das bis mindestens 400°C, insbesondere bis mindestens 800°C, vorzugsweise bis mindestens 1200°C, noch bevorzugter bis mindestens 2000°C, noch bevorzugter bis mindestens 3000°C, thermodynamisch stabil ist, ist die Druckübertragungsplatte mit Vorteil beim Thermokompressionsbonden einsetzbar.

Erfindungsgemäß ist es, wenn die Druckübertragungsplatte aus einem Material gebildet ist, das, insbesondere über einen großen Temperaturbereich, eine gleichbleibende und hohe Druckfestigkeit, insbesondere bei Temperaturen über 400°C, insbesondere größer 500MPa, vorzugsweise größer 1000MPa, noch bevorzugter größer 2000MPa aufweist. Die Druckfestigkeit kann insbesondere durch Begrenzungsmittel am seitlichen Umfang der Druckplatte, erhöht werden (mindestens zweiaxiale Druckfestigkeit),

Denkbare Materialklassen wären insbesondere
Hochtemperaturkunststoffe,
Keramiken, SiC, SiN, etc.
Metalle,
Refraktärmetalle,
Warmfestigkeitsstähle,
allgemeine Werkzeugstähle
oder eine beliebige Kombination der vorher genannten Materialien.

Erfindungsgemäß weist die Druckübertragungsplatte mit Vorteil eine gewisse Elastizität/Verformbarkeit auf, damit Unebenheiten oder eine Welligkeit des Wafers und/oder der Druckübertragungseinrichtung bei der Druckbeaufschlagung ausgeglichen werden.

Erfindungsgemäß ist vorgesehen, dass die Druckübertragungsplatte eine Dicke d kleiner 15mm und größer 1mm aufweist.

Weiterhin ist es von Vorteil, wenn in Weiterbildung der Erfindung zumindest die zweite Druckseite, vorzugsweise die gesamte Druckübertragungsplatte, aus einem Material gebildet ist, das gegenüber dem Wafer bei den gegebenen Bedingungen inert ist und oder nicht mit dem Wafermaterial reagiert und/oder nicht gegenüber dem Wafermaterial löslich ist. Besonders bei Wafern, die Logikfamilien besitzen, welche hochsensibel gegen metallische Verunreinigungen sind, ist die Konzentration der entsprechenden chemischen Elemente zumindest an der zweiten Druckseite, vorzugsweise in der gesamten Druckübertragungsplatte, erfindungsgemäß unter den vorgegebenen Grenzwerten. Im Spezialfall der CMOS Kompatibilität ist der Werkstoff der Druckübertragungsplatte vorzugsweise frei von den Legierungselementen Au, Cu, Ag.

Eine Verringerung und/oder Einstellung einer geringen Adhäsionsfähigkeit ist erfindungsgemäß auch, insbesondere in Kombination mit den anderen erfindungsgemäßen Maßnahmen, durch gezielte Definierung von Luftkanälen entlang der Oberfläche, damit die Ausbildung von Vakuum an der Kontaktfläche minimiert oder verhindert wird.
In einer weiteren erfindungsgemäßen Ausführungsform weist die Ausgleichsplatte eine raue Oberfläche für den Zugang von Gasmolekülen zwischen den Wafer und der Ausgleichsplatte auf. Erfindungsgemäß wird damit durch eine Erzeugung einer rauen Oberfläche durch oben genannte Methoden ein Vakuum zwischen dem Wafer und der Ausgleichsplatte verhindert.

Die zur Druckübertragungsplatte beschriebenen Merkmale sollen auch als Merkmale der beschriebenen Verwendung als offenbart gelten und umgekehrt.

Als eigenständige Erfindung wird auch eine Verwendung der vorbeschriebenen Druckübertragungsplatte zum Bonden, insbesondere Thermokompressionsbonden, offenbart.

Weitere Vorteile, Merkmale und Einzelheiten der Erfindung ergeben sich aus der nachfolgenden Beschreibung bevorzugter Ausführungsbeispiele sowie anhand der Zeichnungen; diese zeigen jeweils in schematischer Ansicht:
- Figur 1: eine schematische Querschnittsansicht einer Bondvorrichtung unter Verwendung einer erfindungsgemäßen Druckübertragungsplatte,
- Figur 2a: eine Aufsicht auf eine erste Ausführungsform der erfindungsgemäßen Druckübertragungsplatte,
- Figur 2b: eine schematische Querschnittsansicht der ersten Ausführungsform der erfindungsgemäßen Druckübertragungsplatte,
- Figur 3a: eine Aufsicht auf eine zweite Ausführungsform der erfindungsgemäßen Druckübertragungsplatte und
- Figur 3b: eine schematische Querschnittsansicht der zweiten Ausführungsform der erfindungsgemäßen Druckübertragungsplatte.

In den Figuren sind Vorteile und Merkmale der Erfindung mit diese jeweils identifizierenden Bezugszeichen gemäß Ausführungsformen der Erfindung gekennzeichnet, wobei Bauteile beziehungsweise Merkmale mit gleicher oder gleichwirkender Funktion mit identischen Bezugszeichen gekennzeichnet sind.

In den Figuren sind die erfindungsgemäßen Merkmale nicht maßstabsgetreu dargestellt, um die Funktion der einzelnen Merkmale überhaupt darstellen zu können. Auch die Verhältnisse der einzelnen Bauteile sind teilweise unverhältnismäßig.

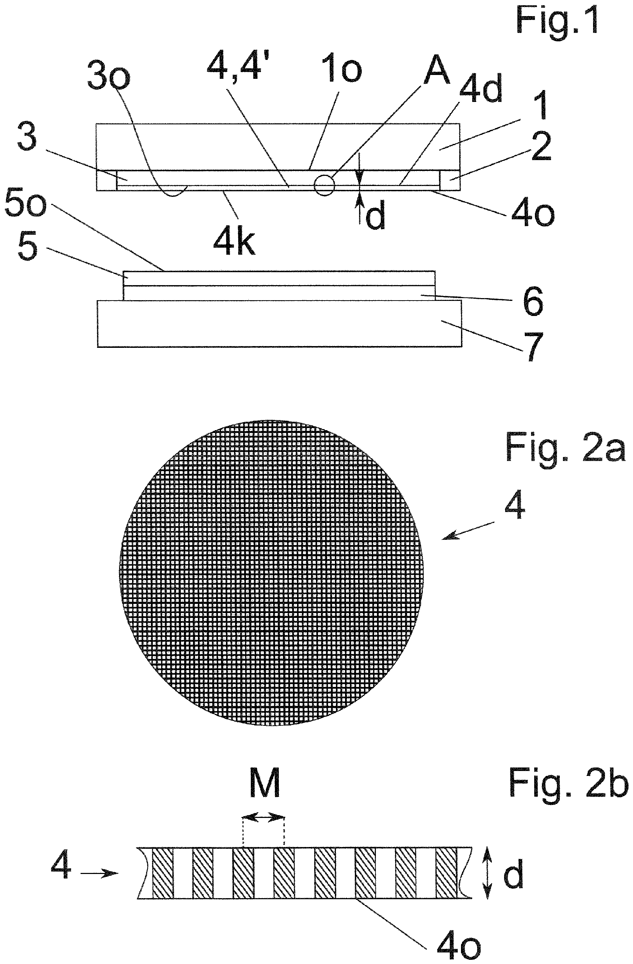

Figur 1 zeigt eine Bondvorrichtung zum Bonden eines ersten Wafers 5 mit einem zweiten Wafer 6, die zu diesem Zweck auf einer Aufnahmeeinrichtung, hier ein Chuck 7, aufgenommen und insbesondere durch Vakuumbahnen, Klemmen etc. fixiert sind.

Die Bondvorrichtung kann insbesondere auch eine Bondkammer aufweisen, in der die in Figur 1 gezeigten Bauteile aufgenommen oder aufnehmbar sind und in der eine definierte Atmosphäre, insbesondere hohe Temperaturen und hohe Drücke oder Unterdruck (Vakuum), hergestellt werden kann.

Oberhalb des Waferpaares aus dem ersten Wafer 5 und dem zweiten Wafer 6 ist eine Druckbeaufschlagungseinrichtung 1 angeordnet, die gegenüber dem Waferpaar ausrichtbar ist und mit der ein Bonddruck oder eine Bondkraft auf das Waferpaar aufgebracht werden kann. Entsprechende Steuereinrichtungen zur gegenüberliegenden Ausrichtung und gleichmäßiger Druckbeaufschlagung sind dem Fachmann bekannt.

An der dem Waferpaar zugewandten Seite 1o der Druckbeaufschlagungseinrichtung 1 wird durch Fixiermittel 2 eine, insbesondere als Graphitplatte ausgebildete, Ausgleichsplatte 3 an der Druckbeaufschlagungseinrichtung 1 fixiert. Die Ausgleichsplatte 3 dient dazu, Unebenheiten der Wafer 5, 6 beziehungsweise des Waferpaares auszugleichen. An der von der Druckbeaufschlagungseinrichtung 1 abgewandten Seite 3o der Ausgleichsplatte 3 wird, insbesondere ebenfalls durch die Fixiermittel 2, eine erfindungsgemäße Druckübertragungsplatte 4 fixiert. Die Druckübertragungsplatte weist eine erste Druckseite 4d auf, mit der sie in Kontakt zu der Seite 3o steht. Weiterhin weist die Druckübertragungsplatte 4 eine von der ersten Druckseite 4d abgewandte zweite Druckseite 4o zur Kontaktierung des Waferpaars, hier des Wafers 5 an dessen Oberfläche 5o, auf.

Bei der gezeigten Ausführungsform weisen die Ausgleichsplatte 3 und die Druckübertragungsplatte 4 an ihrem Seitenumfang im wesentlichen identische Abmessungen auf, die im wesentlichen mit den Abmessungen der Wafer 5, 6 übereinstimmen, diese allenfalls geringfügig überragen oder unterschreiten.

Die Fixiermittel 2 fixieren die Ausgleichsplatte 3 und die Druckübertragungsplatte 4 von deren Seitenumfang her, wobei auch eine Klemmung am Seitenrand der zweiten Druckseite 4o denkbar ist.

Der Bereich der zweiten Druckseite 4o, der mit dem Wafer 5 in Kontakt tritt, ist die wirksame Kontaktfläche 4k, die im vorliegenden Ausführungsbeispiel im Wesentlichen mit der zweiten Druckseite 4o übereinstimmt.

Bevorzugt weisen erfindungsgemäße Druckübertragungsplatten 4, 4' Durchmesser von 4 Zoll, 6 Zoll, 8 Zoll, 12 Zoll oder 18 Zoll auf, damit diese mit den gängigen Industriemaßen von Wafern korrespondieren. Auch beliebig andere Durchmesser sind denkbar.

In der in Figur 2a gezeigten Ausführungsform der Druckübertragungsplatte 4, die im Querschnitt in Figur 2b gemäß Vergrößerung A aus Figur 1 vergrößert dargestellt ist, ist diese als Gitternetz ausgebildet. Die Antihaftwirkung beziehungsweise geringe Adhäsionskraft wird durch eine sehr geringe, aber endliche Maschenweite M hervorgerufen. Die Maschenweite M ist gering genug um eine homogene Druckverteilung der Ausgleichsplatte 3 bestmöglich an die Oberfläche 5o des Wafers 5 weiterzuleiten. Durch die gezeigte Ausführungsform wird die absolute Kontaktfläche zwischen der Druckübertragungsplatte 4 und dem Wafer 5 beziehungsweise die wirksame Kontaktfläche 4k verringert, so dass die Adhäsionswirkung der Druckübertragungsplatte 4 gegenüber dem Wafer 5 minimiert wird und durch entsprechende Materialwahl so klein wird, dass ein Anhaften des Waferpaares an der Druckübertragungsplatte 4 nicht mehr erfolgt.

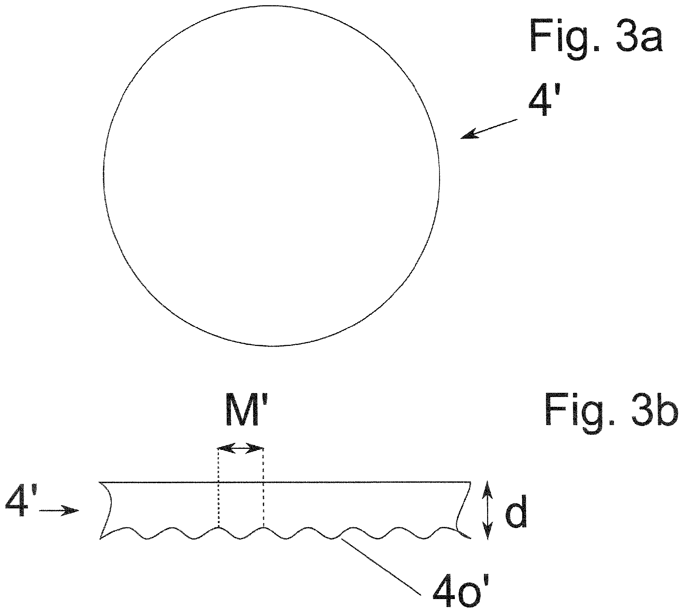

In der in Figur 3a und 3b gezeigten Ausführungsform der Druckübertragungsplatte 4', insbesondere als Blech oder Folie ausgebildet, weist die zweite Druckseite 4o' eine hohe Oberflächenrauigkeit auf. Die Oberflächenrauigkeit kann insbesondere nasschemisch hergestellt werden. Durch den gezielten Einsatz von Säure wird die Oberfläche 4o' erodiert. Insbesondere anschließend oder ausschließlich kann durch Kugelstrahlen, Sandstrahlen, Schleifen und/oder Polieren mit entsprechend großen Körnungen eine dezidierte Oberflächenrauigkeit hergestellt werden.

Im Zusammenwirken der Druckübertragungsplatte 4' mit der Ausgleichsplatte 3 wird trotzdem eine gute Druckverteilung und homogene Bondkraftbeaufschlagung ermöglicht.

Dabei ist die Druckübertragungsplatte 4' elastisch genug, um sich an Unebenheiten der darüber liegenden Ausgleichsplatte 3 und/oder des mit Bondkraft zu beaufschlagenden Wafers 5 anzupassen.

Als Material für erfindungsgemäße Druckübertragungsplatten 4, 4' kommen insbesondere Stähle und/oder Refraktärmetalle, insbesondere deren Legierungen, zum Einsatz. Vorzugsweise werden warmfeste Stähle verwendet.

Die Druckübertragungsplatten 4, 4' weisen eine Dicke d auf, um eine ausreichende Biegesteifigkeit zur Fixierung von deren Seite her, nämlich über die Fixiermittel 2, zu ermöglichen. Die Fixiermittel 2 weisen insbesondere Fixierelemente auf, die am Umfang der Druckübertragungsplatte 4, 4' verteilt angeordnet sind.

Als Fixiermittel kommt auch eine direkte Verbindung mit der Ausgleichsplatte 3 in Frage, insbesondere durch Hochtemperaturkleber und/oder Einbetten des Materials der Druckübertragungsplatte 4, 4' in eine Graphitmatrix der Ausgleichsplatte 3. Gemäß einer weiteren Ausführungsform wird das Gitternetz gemäß Ausführungsform der Figuren 2a und 2b und die Graphitschicht 3 einen, in Druckrichtung betrachteten, Seriellverbund, insbesondere durch Einbetten des, insbesondere metallischen, Gitternetzes in die weichere Graphitschicht 3.

### Bezugszeichenliste

- 1: Druckbeaufschlagungseinrichtung
- 1o: Seite
- 2: Fixiermittel
- 3: Ausgleichsplatte
- 3o: Seite
- 4, 4': Druckübertragungsplatte
- 4o, 4o': Zweite Druckseite
- 4d: Erste Druckseite
- 4k: Kontaktfläche
- 5: Erster Wafer
- 5o: Oberfläche
- 6: Zweiter Wafer
- 7: Chuck
- d: Dicke
- M: Maschenweite
- M': Oberflächenrauhigkeit

## Patentansprüche

1. Druckübertragungsplatte (4, 4') zur Druckübertragung eines Bondingdrucks beim Thermokompressionsbonden, von einer Druckbeaufschlagungseinrichtung (1) auf einen Wafer (5) mit:
- einer ersten Druckseite (4d) zur Kontaktierung der Druckbeaufschlagungseinrichtung (1),
- einer von der ersten Druckseite (4d) abgewandten zweiten Druckseite (4o, 4o') mit einer wirksamen Kontaktfläche (4k) zur Kontaktierung und Druckbeaufschlagung des Wafers (5), wobei zumindest die wirksame Kontaktfläche (4k) eine geringe Adhäsionsfähigkeit gegenüber dem Wafer (5) aufweist, wobei die Druckübertragungsplatte (4, 4') als Gitternetz ausgebildet ist, **dadurch gekennzeichnet, dass** die Druckübertragungsplatte (4, 4') eine Dicke d kleiner 15mm und größer 1mm aufweist, wobei das Material der Druckübertragungsplatte (4, 4') eine Druckfestigkeit größer 500 MPa aufweist.

2. Druckübertragungsplatte gemäß Patentanspruch 1, bei der die Adhäsionsfähigkeit definiert ist durch eine Oberflächenenergie kleiner 0,1 J/m², insbesondere kleiner 0,01 J/m², vorzugsweise kleiner 0,001 J/m², noch bevorzugter kleiner 0,0001 J/m², idealerweise kleiner 0,00001 J/m².

3. Druckübertragungsplatte nach einem der vorhergehenden Patentansprüche, bei der die Adhäsionsfähigkeit der Kontaktfläche (4k) mit einem Kontaktwinkel größer 20°, insbesondere größer 50°, vorzugsweise größer 90°, noch bevorzugter größer 150° definiert ist,

4. Druckübertragungsplatte nach einem der vorhergehenden Ansprüche, bei der das Gitternetz eine Maschenweite M kleiner 2mm, bevorzugt kleiner 1mm, bevorzugter kleiner 0.5mm, noch bevorzugter kleiner 0.1mm, am bevorzugtesten kleiner 0.01mm aufweist.

5. Druckübertragungsplatte nach einem der vorhergehenden Ansprüche, bei der die Druckübertragungsplatte (4, 4') aus einem Material gebildet ist, das bis mindestens 400°C, insbesondere bis mindestens 800°C, vorzugsweise bis mindestens 1200°C, noch bevorzugter bis mindestens 2000°C, noch bevorzugter bis mindestens 3000°C, thermodynamisch stabil ist.

6. Druckübertragungsplatte nach einem der vorhergehenden Ansprüche, bei der zumindest die zweite Druckseite (4o, 40'), vorzugsweise die gesamte Druckübertragungsplatte (4, 4'), aus einem Material gebildet ist, das gegenüber dem Wafer (5) bei den gegebenen Bedingungen inert ist und oder nicht mit dem Wafermaterial reagiert und/oder nicht gegenüber dem Wafermaterial löslich ist,

7. Verwendung einer Druckübertragungsplatte (4, 4') gemäß einem der vorhergehenden Patentansprüche beim Thermokompressionsbonden.

## Claims

1. A pressure transfer disk (4, 4') for transfer of a bonding pressure in thermocompression bonding from a pressurization apparatus (1) to a wafer (5) with the following:
- a first pressure side (4d) for making contact with the pressurization apparatus (1),
- a second pressure side (4o, 4o') facing away from the first pressure side (4d) with an effective contact area (4k) for making contact with the wafer (5) and pressurizing it, at least the effective contact area (4k) having a low adhesiveness relative to the wafer (5), **characterized in that** the pressure transfer disk (4, 4') is made as a lattice network, wherein the pressure transfer disk (4, 4') has a thickness d less than 15mm and greater that 1mm, wherein the material of the pressure transfer disk (4, 4') has a compressive strength greater than 500 MPa.

2. The pressure transfer disk as claimed in Claim 1, wherein the adhesiveness is defined by a surface energy of less than 0.1 J/m², especially less than 0.01 J/m², preferably less than 0.001 J/m², even more preferably less than 0.0001 J/m², ideally less than 0.00001 J/m².

3. The pressure transfer disk as claimed in one of the preceding claims, wherein the adhesiveness of the contact area (4k) is defined with a contact angle greater than 20°, especially greater than 50°, preferably greater than 90°, even more preferably greater than 150°.

4. The pressure transfer disk as claimed in one of the preceding claims, wherein the lattice network has a mesh width M less than 2 mm, preferably less than 1 mm, more preferably less than 0.5 mm, even more preferably less than 0.1 mm, most preferably less than 0.01 mm.

5. The pressure transfer disk as claimed in one of the preceding claims, wherein the pressure transfer disk (4, 4') is formed from a material which is thermodynamically stable up to at least 400°C, especially up to at least 800°C, preferably up to at least 1200°C, even more preferably up to at least 2000°C, still more preferably up to at least 3000°C.

6. The pressure transfer disk as claimed in one of the preceding claims, wherein at least the second pressure side (4o, 4o'), preferably the entire pressure transfer disk (4, 4'), is formed from a material which is inert relative to the wafer (5) under given conditions and/or does not react with the wafer material and/or is not soluble relative to the wafer material.

7. An application of a pressure transfer disk (4, 4') as claimed in one of the preceding claims during thermocompression bonding.

## Revendications

1. Plaque de transfert de pression (4, 4') pour le transfert de pression d'une pression de collage dans le collage par thermocompression, d'un dispositif d'application de pression (1) sur une tranche (5) comprenant :
- une première face de compression (4d) pour la mise en contact du dispositif d'application de pression (1),
- une seconde face de compression (40, 40') détournée de la première face de compression (4d) avec une surface de contact active (4k) pour la mise en contact et l'application de compression sur la tranche (5), dans laquelle au moins la surface de contact active (4k) présente une capacité d'adhérence faible par rapport à la tranche (5), dans laquelle la plaque de transfert de pression (4, 4') est formée en tant que quadrillage,
**caractérisé en ce que** la plaque de transfert de pression (4, 4') présente une épaisseur d inférieure à 15mm et supérieure à 1mm, dans laquelle le matériau de la plaque de transfert de pression (4, 4') présente une résistance à la pression supérieure à 500 MPa.

2. Plaque de transfert de pression selon la revendication 1, dans laquelle la capacité d'adhérence est définie par une énergie de surface inférieure à 0,1 J/m², en particulier inférieure à 0,01 J/m², de préférence inférieure à 0,001 J/m², plus encore de préférence inférieure à 0,0001 J/m², idéalement inférieure à 0,00001 J/m².

3. Plaque de transfert de pression selon l'une des revendications précédentes, dans laquelle la capacité d'adhérence de la surface de contact (4k) est définie par un angle de contact supérieur à 20°, en particulier supérieur à 50°, de préférence supérieur à 90°, plus encore de préférence supérieur à 150°.

4. Plaque de transfert de pression selon l'une des revendications précédentes, dans laquelle le quadrillage présente une largeur de maille M inférieure à 2mm, de préférence inférieure à 1mm, encore de préférence inférieure à 0,5mm, plus encore de préférence inférieure à 0,1mm, de la manière préférée entre toutes inférieure à 0,01 mm.

5. Plaque de transfert de pression selon l'une des revendications précédentes, dans laquelle la plaque de transfert de pression (4, 4') est formée dans un matériau qui est thermodynamiquement stable jusqu'au moins 400°C, en particulier jusqu'au moins 800°C, de préférence jusqu'au moins 1200°C, plus encore de préférence jusqu'au moins 2000°C, plus encore de préférence jusqu'au moins 3000°C.

6. Plaque de transfert de pression selon l'une des revendications précédentes, dans laquelle au moins la seconde face de compression (40, 40'), de préférence toute la plaque de transfert de pression (4, 4') est formée dans un matériau qui est inerte par rapport à la tranche (5) dans les conditions données ou ne réagit par avec le matériau de la tranche et/ou n'est pas soluble par rapport au matériau de la tranche.

7. Emploi d'une plaque de transfert de pression (4, 4') selon l'une des revendications de brevet précédentes dans le collage par thermocompression.
